# EUROPEAN PATENT APPLICATION

(11) **EP 4 502 631 A1**
(43) Date of publication of application: **05.02.2025**
(21) Application number: 24781235.7
(22) Date of filing: 28.03.2024
(51) Int. Cl.: G01R 31/317, G01R 31/3183, G01R 31/40, G01R 19/25, G01R 31/52, G01R 19/165

(54) **METHOD AND DEVICE FOR DETECTING WHETHER FAILURE HAS OCCURRED IN INVERTER**

(30) Priority: 28.03.2023 KR 20230040400
(71) Applicant: Hanwha Solutions Corporation, Jung-gu Seoul 04541 (KR)
(72) Inventor: JUNG, Kyung Su, Seoul 04541 (KR); LEE, Su Chang, Seoul 04541 (KR); KANG, Youn Jong, Seoul 04541 (KR); YUN, Ju Hwan, Seoul 04541 (KR); LEE, Jae Dong, Seoul 04541 (KR); CHO, Jun Seong, Seoul 04541 (KR)
(74) Representative: Mooser, Sebastian Thomas
(86) International application number: PCT/KR2024/003905
(87) International publication number: WO 2024/205245

(57) **Abstract**

Provided is a method of detecting whether an inverter fails, the method including stopping an operation of the inverter, setting a plurality of pins constituting a processor as output ports or input ports, and detecting whether the inverter fails, based on an operation with respect to at least one pin set as an output port or an input port among the plurality of pins.

## Description

### Technical Field

The present disclosure relates to a method and apparatus for detecting whether an inverter fails.

### Background Art

Inverters are devices that convert direct current into alternating current, and are used in industrial fields using various electronic devices such as not only motor-driven drives, uninterruptible power supply (UPS), active power filters, etc., but also renewable energy systems, hybrid vehicles, etc.

Although inverter design and control technology is advancing, many types of unexpected inverter failures frequently occur. Failures of an inverter may include digital input/output errors of a processor connected to or included in the inverter. In this case, the digital input/output errors may affect an operation of the inverter. Hence, to increase the reliability of the inverter and eliminate adverse effects caused by a failure of the inverter, detection of the digital input/output errors is required.

### Disclosure

### Technical Problem

The present disclosure provides a method and apparatus for detecting whether an inverter fails. The present disclosure also provides a computer-readable recording medium having recorded thereon a program for executing the method on a computer. The technical problems of the present disclosure are not limited to the aforementioned technical problems, and other technical problems may exist.

### Technical Solution

According to one aspect, a method of detecting whether an inverter fails includes stopping an operation of the inverter, setting a plurality of pins constituting a processor as output ports or input ports, and detecting whether the inverter fails, based on an operation with respect to at least one pin set as an output port or an input port among the plurality of pins.

A computer-readable recording medium according to another aspect includes a recording medium having recorded thereon a program for executing the above-described method on a computer.

According to another aspect, a processor is configured to stop an operation of the inverter, set a plurality of pins constituting a processor as output ports or input ports, and detect whether the inverter fails, based on an operation with respect to at least one pin set as an output port or an input port among the plurality of pins.

### Advantageous Effects

Without addition of a separate circuit, digital input/output errors occurring in a processor may be checked while the inverter is stopped. Therefore, a failure of the inverter may be easily and accurately checked before power is supplied to the inverter.

### Description of Drawings

FIG. 1 is a diagram illustrating an example of a processor and elements connected to the processor according to one aspect.
FIG. 2 is a flowchart showing an example of a method of detecting whether an inverter fails, according to one aspect.
FIG. 3 is a flowchart showing an example in which a processor detects whether an inverter fails, according to one aspect.
FIG. 4 is a flowchart showing an example to check an error by setting a pin of a processor as an output port, according to one aspect.
FIGS. 5 and 6 are diagrams to describe examples of a method of causing a short, according to one aspect.
FIG. 7 is a flowchart showing an example to check an error by setting a pin of a processor as an input port, according to one aspect.

### Best Mode

According to one aspect, a method of detecting whether an inverter fails includes stopping an operation of the inverter, setting a plurality of pins constituting a processor as output ports or input ports, and detecting whether the inverter fails, based on an operation with respect to at least one pin set as an output port or an input port among the plurality of pins.

### Mode for Invention

Although terms used in embodiments are selected with general terms popularly used at present as much as possible, the terms may vary according to the intention of those of ordinary skill in the art, judicial precedents, or introduction of new technology. In addition, in a specific case, the applicant voluntarily may select terms, and in this case, the meaning of the terms may be disclosed in detail in a corresponding description part. Thus, the terms used herein should be defined not by the simple names of the terms but by the meaning of the terms and the contents throughout the present specification.

Throughout the entirety of the specification, when a certain part "includes" a certain component, it may mean that the component may further include other components rather than exclude other components, unless specially described to the contrary.

In addition, terms, such as "first", "second", etc., used herein, may be used to describe various components, but the components should not be limited by the terms. These terms are used to distinguish one component from another component.

Hereinafter, preferred embodiments of the present disclosure will be described in detail with reference to the attached drawings. The detailed description set forth below in conjunction with the accompanying drawings is intended to describe example embodiments of the present disclosure and is not intended to represent the only embodiment in which the present disclosure may be practiced. In the drawings, to clearly describe the present disclosure, parts unrelated to the description may be omitted, and the same reference numerals may be used for the same or similar components throughout the specification.

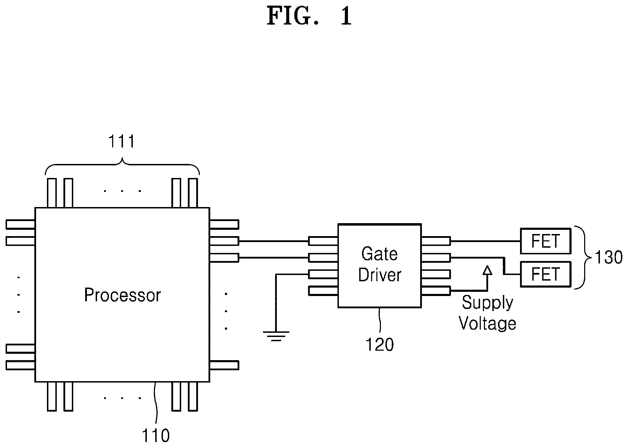

FIG. 1 is a diagram illustrating an example of a processor and elements connected to the processor according to one aspect.

Referring to FIG. 1, a processor 110 may be connected to at least one termination device 130 through a gate driver 120. For example, the termination device 130 may be, but not limited to, a field effect transistor (FET). The processor 110 may also include pins 111 by which and the processor 110 and the gate driver 120 may be connected to each other.

For example, at least one of the processor 110, the gate driver 120, and the termination device 130 may be included in the inverter. Alternatively, at least one of the processor 110, the gate driver 120, and the termination device 130 may be connected to the inverter.

The inverter may be included in a power generation device or system using renewable energy (e.g., solar heat, solar energy, biomass, wind power, small hydro, geothermal heat, marine energy, waste energy, etc.). For example, for a solar energy generation device or system, the inverter may be a micro inverter or string inverter connected to at least one photovoltaic (PV) module. When the inverter is a string inverter, an optimizer may be connected to the PV module.

However, a device or system including the inverter is not limited to the example described above. For example, as long as a device needs to convert power from direct current to alternating current, or from alternating current to direct current, the inverter may be included in the device or in the system without a limitation. For example, any processor included in a device or system that needs to convert power may be the processor 110 without a limitation.

The processor 110 may process an instruction of a computer program by performing basic arithmetic, logic, and input/output operations. Here, the instruction may be provided from an internal memory of the processor 110 or from an external device. The processor 110 may generally control operations of other components included in the inverter.

For example, the processor 110 may be implemented as an array of multiple logic gates, or may be implemented as a combination of a general-purpose microprocessor and a memory storing a program executable on the microprocessor. For example, the processor 110 may include a general-purpose processor, a central processing unit (CPU), a graphics processing unit (GPU), a neural network processing unit (NPU), a microprocessor, a digital signal processor (DSP), a controller, a microcontroller, a state machine, etc. In some environments, the processor 110 may include an application specific integrated circuit (ASIC), a programmable logic device (PLD), a field programmable gate array (FPGA), etc. For example, the processor 110 may refer to a combination of a DSP and a microprocessor, a combination of a plurality of microprocessors, a combination of one or more microprocessors combined with a DSP core, or a combination of processing devices such as any combination of other such components.

Meanwhile, the processor 110 may include a memory, although not shown in FIG. 1. For example, the memory may include any non-transitory computer-readable recording medium.

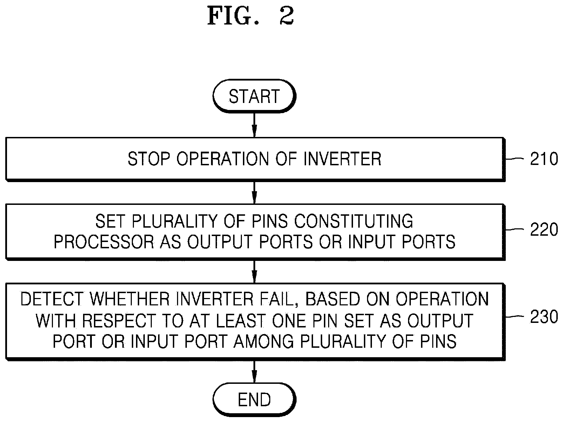

As an example, the memory may include a permanent mass storage device such as random access memory (RAM), read only memory (ROM), disk drive, solid state drive (SSD), flash memory, etc. As another example, a non-perishable mass storage device such as ROM, SSD, flash memory, disk drives, etc., may be a separate permanent storage device distinct from the memory. An operating system (OS) and at least one program code (e.g., a code for the processor 110 to perform operations to be described later with reference to FIGS. 2 to 7) may be stored in the memory.

These software components may be loaded from a computer-readable recording medium separate from the memory. This separate computer-readable recording medium may be a recording medium that may be directly connected to a computer, and include a computer-readable recording medium, for example, floppy drive, disk, tape, DVD/CD-ROM drive, memory card, etc. Alternatively, software components may be loaded onto the memory through a communication device rather than a computer-readable recording medium. For example, at least one program may be loaded onto the memory based on a computer program (e.g., a computer program for the processor 110 to perform operations to be described later with reference to FIGS. 2 to 7) installed by files provided through the communication device by developers or a file distribution system that distributes an installation file of an application.

Digital input/output errors of the processor 110 may affect an operation of the inverter. To prevent the digital input/output errors of the processor 110, the processor 110 needs to satisfy functional safety (UL991) standard certification. In particular, it should be determined whether a function of the processor 110 satisfies digital input/output diagnostic items among internal safety diagnostic items. Here, a digital input/output diagnostic item may refer to an item for diagnosing whether the pins 111 included in the processor 110 properly perform input and output functions.

In general, when an error occurs during an operation of the inverter, it may be determined whether a digital input/output error occurs in the processor 110, based on a sensing value output from or input to the inverter. However, in the above-described method, it is difficult to determine in which of the pins 111 the error has occurred. In addition, when using the above-described method, a separate circuit needs to be added to the processor 110 to identify a type of the pin in which the error has occurred. To determine whether the digital input/output error of the processor 110 has occurred, the inverter has to operate.

The processor 110 according to one embodiment may check a digital input/output error occurring in the processor 110 even when the inverter is stopped, without addition of a separate circuit. Therefore, a failure of the inverter may be easily and accurately checked before power is supplied to the inverter.

FIG. 2 is a flowchart showing an example of a method of detecting whether an inverter fails, according to one aspect.

The method shown in FIG. 2 may include operations processed in time series in the processor 110 shown in FIG. 1. Therefore, the foregoing description of the processor 110, even though being omitted below, may be applied to the method shown in FIG. 2.

In operation 210, the processor 110 may stop the operation of the inverter.

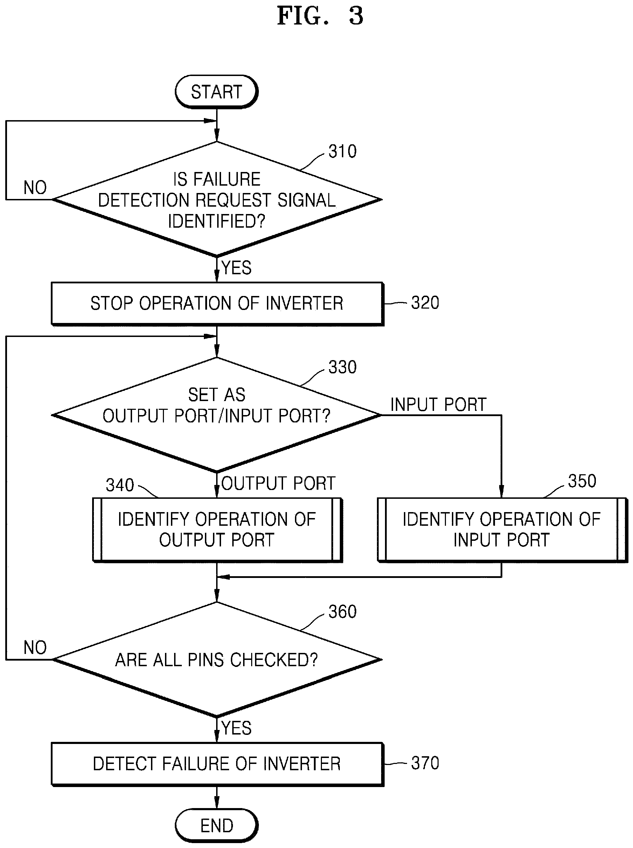

For example, when a signal requesting detection of a failure of the inverter (hereinafter referred to as a 'failure detection request signal') is identified, the processor 110 may stop the operation of the inverter. An example in which the processor 110 stops the operation of the inverter will be described later with reference to operations 310 and 320 of FIG. 3.

In operation 220, the processor 110 may set a plurality of pins 111 constituting the processor 110 as output ports or input ports.

For example, the processor 110 may set at least one pin among the plurality of pins 111 constituting the processor 110 as an output port or an input port to check a digital input/output error. An example in which the processor 110 sets a pin as an output port or an input port will be described later with reference to operation 330 of FIG. 3.

In operation 230, the processor 110 may detect whether the inverter fails, based on an operation with respect to the at least one pin among the plurality of pins 111 set as the output ports or the input ports.

The processor 110 may identify an operation with respect to at least one pin set as an output port. For example, the processor 110 may generate an output signal by setting the at least one pin as the output port. The processor 110 may convert the pin set as the output port to an input port and receive an input signal corresponding to the output signal. Then, the processor 110 may determine whether an error has occurred in the at least one pin, by comparing the output signal with the input signal.

As an example, the processor 110 may compare the output signal generated from the at least one pin with an input signal, received from the at least one pin due to a ground short, to determine whether an error has occurred in the at least one pin. As another example, the processor 110 may compare the output signal generated from the at least one pin with an input signal, received from the at least one pin due to a supply voltage short, to determine whether an error has occurred in the at least one pin.

The processor 110 may identify an operation with respect to at least one pin set as an input port. For example, the processor 110 may set the at least one pin as the input port and determine whether an error has occurred in the at least one pin, based on a signal received from the termination device 130 of the processor 110. Specifically, the processor 110 may identify a normal range of a signal strength corresponding to the termination device 130, and the processor 110 may receive a signal from the termination device 130. The processor 110 may determine whether an error has occurred in the at least one pin, based on whether the strength of the received signal is within the normal range.

An example in which the processor 110 detects whether the inverter fails, based on the operation with respect to the pin, will be described later with reference to operations 340 to 370 of FIG. 3.

FIG. 3 is a flowchart showing an example in which a processor detects whether an inverter fails, according to one aspect.

In operation 310, the processor 110 may identify a failure detection request signal of the inverter.

For example, the failure detection request signal may be generated according to a preset detection cycle or may be input from a manager of the inverter. When the failure detection request signal is identified, the processor 110 may perform operation 320. When the failure detection request signal is not identified, the processor 110 may continuously monitor whether the failure detection request signal is identified.

In operation 320, the processor 110 may stop an operation of the inverter. For example, the inverter may be connected to the processor 110 as a separate device, or the processor 110 may be included in the inverter.

In operation 330, the processor 110 may set at least one pin among the plurality of pins 111 constituting the processor 110 as an output port or an input port to check a digital input/output error. When the processor 110 sets the at least one pin as the output port, the processor 110 may perform operation 340. When the processor 110 sets the at least one pin as the input port, the processor 110 may perform operation 350.

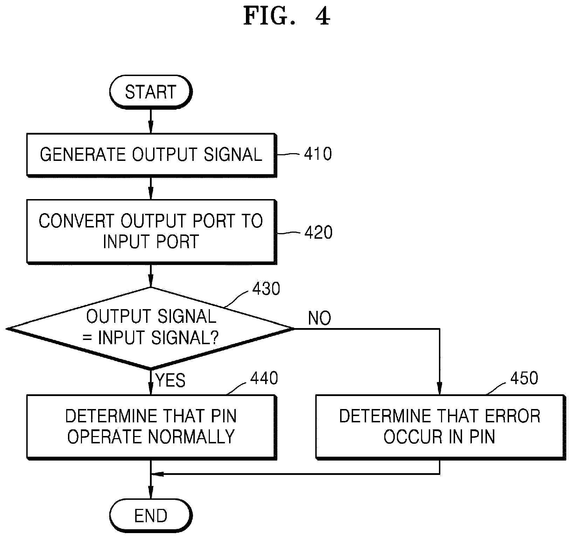

In operation 340, the processor 110 may identify the operation with respect to the at least one pin set as the output port and perform operation 360. Hereinbelow, an example in which the processor 110 identifies the operation with respect to the at least one pin set as the output port will be described with reference to FIG. 4.

FIG. 4 is a flowchart showing an example to check an error by setting a pin of a processor as an output port, according to one aspect.

In operation 410, the processor 110 may generate an output signal that may be output from the output port. In operation 420, the processor 110 may convert the pins 111 set as output ports into input ports.

In operation 430, the processor 110 may determine whether the output signal output from the pin is the same as the input signal input to the pin. For example, the processor 110 may output an output signal through a pin connected to the gate driver 120 among the pins 111 set as the output ports. The processor 110 may change a pin set as an output port to an input port. Then, the processor 110 may receive a signal corresponding to the output signal as an input signal through the pin changed to the input port and identify the received signal.

Through the above-described process, the processor 110 may identify, as an input signal, a signal before the output signal is output and discharged. For example, a time when an output signal is output may be shorter than a time when a pin set as an output port is changed to an input port. In addition, after the output signal is output, a time until the output signal is erased due to the pin set as the output port being changed to the input port may be longer than a time in which an error is checked.

When the output signal and the input signal are the same as each other, the processor 110 may determine that the corresponding pin operates normally, in operation 440. When the output signal and the input signal are different from each other, the processor 110 may determine that an error has occurred in the corresponding pin, in operation 450.

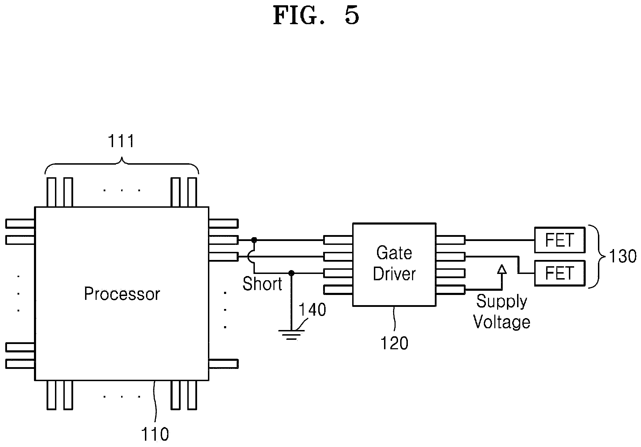

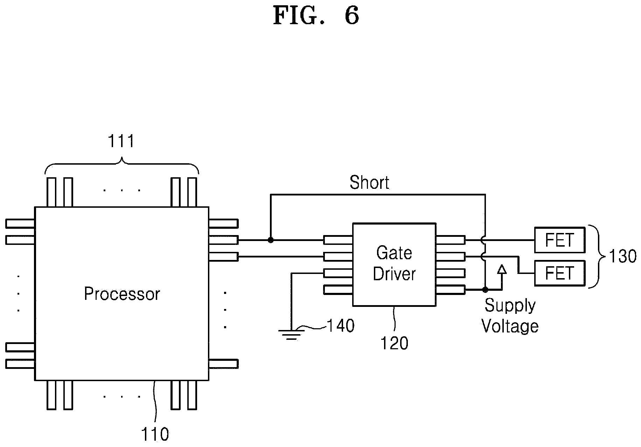

For example, the processor 110 may detect a short that occurs while checking an error of the pin. Hereinafter, examples in which the processor 110 detects a short will be described with reference to FIGS. 5 and 6.

FIGS. 5 and 6 are diagrams to describe examples of a method of causing a short, according to one aspect.

Referring to FIG. 5, the gate driver 120 connected to the processor 110 may be connected to a ground 140. The processor 110 may identify a case where an abnormal input signal is transmitted to at least one pin of the processor 110 due to occurrence of a ground short to determine whether an error has occurred in the corresponding pin.

When the ground short occurs in the ground 140 connected to the gate driver 120, a signal (e.g., 0 V) output from the ground 140 due to the ground short may be input to the pin set as the input pin. When the input signal input from the input pin (for example, the input signal due to the ground short) is 0 V, the processor 110 may determine that the corresponding pin operates normally even in a situation where the ground short occurs. Alternatively, when the input signal is not 0 V, the processor 110 may determine that an error has occurred in the corresponding pin.

Referring to FIG. 6, a supply voltage may be connected to the gate driver 120 connected to the processor 110. The processor 110 may identify a case where an abnormal input signal is transmitted to at least one pin due to occurrence of a supply voltage short to determine whether an error has occurred in the corresponding pin.

When the supply voltage short occurs in the supply voltage connected to the gate driver 120, a signal (e.g., 5 V) output from the supply voltage due to the supply voltage short may be input to the pin set as the input pin. When the input signal input from the input pin (for example, the input signal due to the supply voltage short) is 5 V, the processor 110 may determine that the corresponding pin operates normally even in a situation where the supply voltage short occurs. Alternatively, when the input signal is not 5 V, the processor 110 may determine that an error has occurred in the corresponding pin.

Referring back to FIG. 3, in operation 360, the processor 110 may determine whether all pins 111 constituting the processor 110 have been checked for a failure. When operation states of all the pins 111 are identified, the processor 110 may perform operation 370. Alternatively, when the operation states of all the pins 111 are not identified, the processor 110 may perform operations 330 and 340 again. At this time, the processor 110 may identify the operation states of all the pins 111 and an operation state of a pin connected to the gate driver 120.

In operation 370, the processor 110 may determine whether there is an error in at least one pin provided in the processor 110, based on a result of identifying an operation state of a pin set as an output port. Based on the determination, the processor 110 may determine whether the inverter fails.

For example, when it is determined that the error has occurred in the at least one pin among all the pins 111, the processor 110 may determine that the failure has occurred in the inverter.

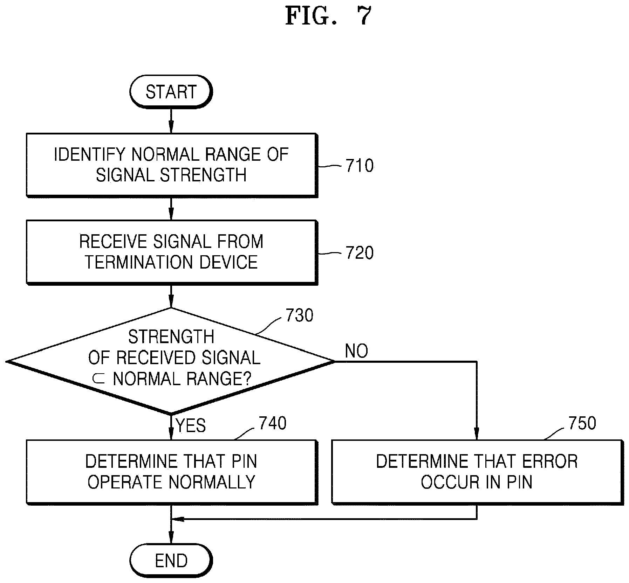

In operation 350, the processor 110 may identify an operation with respect to a pin set as an input port. Then, the processor 110 may perform operation 360. Hereinbelow, an example in which the processor 110 identifies the operation with respect to the pin set as the input port will be described with reference to FIG. 7.

FIG. 7 is a flowchart showing an example to check an error by setting a pin of a processor as an input port, according to one aspect.

In operation 710, the processor 110 may identify a normal range of a signal strength corresponding to the termination device 130. In operation 720, the processor 110 may receive a signal from the termination device 130 through the gate driver 120.

In operation 730, the processor 110 may determine whether the strength of the signal received from the termination device 130 is within the normal range.

When the strength of the received signal is within the normal range, the processor 110 may perform operation 740. In operation 740, the processor 110 may determine that the corresponding pin operates normally when the strength of the received signal is within the normal range.

When the strength of the received signal is not within the normal range, the processor 110 may perform operation 750. In operation 750, the processor 110 may determine that the corresponding pin does not operate normally when the strength of the received signal is not within the normal range.

Referring back to FIG. 3, in operation 360, the processor 110 may determine whether all the pins 111 constituting the processor 110 have been checked for a failure.

When the check for the failure of all the pins 111 is not completed, the processor 110 may perform operations 330 and 350 again. When the check for the failure of all the pins 111 is completed, the processor 110 may perform operation 370.

In operation 370, the processor 110 may determine whether there is an error in the at least one pin, based on a result of identifying an operation state of a pin set as an input port. For example, the processor 110 may identify the operation states of all the pins 111 and an operation state of a pin connected to the termination device 130.

Based on the determination, the processor 110 may determine whether the inverter fails.

According to the foregoing description, the processor 110 according to one embodiment may check a digital input/output error occurring in the processor 110 even when the inverter is stopped, without addition of a separate circuit. Therefore, a failure of the inverter may be easily and accurately checked before power is supplied to the inverter.

Meanwhile, the above-described method may be written as a program executable on a computer, and may be implemented in a general-purpose digital computer that operates the program using a computer-readable recording medium. Additionally, a data structure used in the above-described method may be recorded on a computer-readable recording medium through various means. The computer-readable recording medium may include a storage medium such as a magnetic storage medium (e.g., ROM, RAM, USB, floppy disk, hard disk, etc.) and an optical read medium (e.g., CD-ROM, DVD, etc.).

The embodiments of the present disclosure set forth herein and in the drawings are merely provided as specific examples to easily describe the technical content of the present disclosure and to facilitate understanding of the present disclosure, and are not intended to limit the scope of the present disclosure. Therefore, the scope of the present disclosure should be construed as including all changes or modified forms derived based on the technical spirit of the present disclosure as well as the embodiments disclosed herein.

## Claims

1. A method of detecting whether an inverter fails, the method comprising:
stopping an operation of the inverter;
setting a plurality of pins constituting a processor as output ports or input ports; and
detecting whether the inverter fails, based on an operation with respect to at least one pin set as an output port or an input port among the plurality of pins.

2. The method of claim 1, wherein the detecting comprises identifying the operation with respect to the at least one pin set as the output port.

3. The method of claim 2, wherein the detecting comprises:
setting the at least one pin as the output port to generate an output signal;
converting the at least one pin set as the output port into an input port to receive an input signal corresponding to the output signal; and
comparing the output signal with the input signal to determine whether an error has occurred in the at least one pin.

4. The method of claim 3, wherein the detecting comprises detecting whether an error has occurred in the at least one pin by comparing an output signal generated from the at least one pin with an input signal received from the at least one pin due to a ground short.

5. The method of claim 4, wherein the detecting comprises detecting whether an error has occurred in the at least one pin by comparing the output signal generated from the at least one pin with an input signal received from the at least one pin due to a supply voltage short.

6. The method of claim 1, wherein the detecting comprises identifying the operation with respect to the at least one pin set as the input port.

7. The method of claim 6, wherein the detecting comprises:
setting the at least one pin as the input port; and
determining whether an error has occurred in the at least one pin, based on a signal received from a device connected to a terminal of the processor.

8. The method of claim 7, wherein the detecting comprises:
identifying a normal range of a signal strength corresponding to the device connected to the terminal;
receiving a signal from the device connected to the terminal; and
determining whether an error has occurred in the at least one pin, based on whether a strength of the received signal is within the normal range.

9. A computer-readable recording medium having recorded thereon a program for causing a computer to execute the method of claim 1.

10. A processor configured to:
stop an operation of an inverter;
set a plurality of pins constituting a processor as output ports or input ports; and
detect whether the inverter fails, based on an operation with respect to at least one pin set as an output port or an input port among the plurality of pins.

11. The processor of claim 10, wherein the processor is further configured to identify the operation with respect to the at least one pin set as the output port.

12. The processor of claim 11, wherein the processor is further configured to:
set the at least one pin as the output port to generate an output signal;
convert the at least one pin set as the output port into an input port to receive an input signal corresponding to the output signal; and
compare the output signal with the input signal to determine whether an error has occurred in the at least one pin.

13. The processor of claim 12, wherein the processor is further configured to detect whether an error has occurred in the at least one pin by comparing an output signal generated from the at least one pin with an input signal received from the at least one pin due to a ground short.

14. The processor of claim 13, wherein the processor is further configured to detect whether an error has occurred in the at least one pin by comparing the output signal generated from the at least one pin with an input signal received from the at least one pin due to a supply voltage short.

15. The processor of claim 10, wherein the processor is further configured to identify the operation with respect to the at least one pin set as the input port.

16. The processor of claim 15, wherein the processor is further configured to set the at least one pin as the input port and determine whether an error has occurred in the at least one pin, based on a signal received from a device connected to a terminal of the processor.

17. The processor of claim 16, wherein the processor is further configured to:
identify a normal range of a signal strength corresponding to the device connected to the terminal;
receive a signal from the device connected to the terminal; and
determine whether an error has occurred in the at least one pin, based on whether a strength of the received signal is within the normal range.
